# EUROPEAN PATENT SPECIFICATION

(11) **EP 1 581 668 B1**
(45) Date of publication and mention of the grant of the patent: **10.11.2010**
(21) Application number: 03768404.0
(22) Date of filing: 19.12.2003
(51) Int. Cl.: C23F 1/16, H01L 21/306, H01L 21/311, H01L 21/465, H01P 11/00, H01S 5/323

(54) **ETCHING OF ALGAINASSB**
ALGAINASSB-ÄTZUNG
GRAVURE D'ALGAINASSB

(30) Priority: 27.12.2002 NO 20026261
(43) Date of publication of application: 05.10.2005
(73) Proprietor: Integrated Optoelectronics AS, 7075 Tiller (NO)
(72) Inventor: BUGGE, Renato, N-7041 Trondheim (NO); FIMLAND, Björn-Ove, N-7036 Trondheim (NO)
(74) Representative: Furan, Tone
(86) International application number: PCT/NO2003/000429
(87) International publication number: WO 2004/059038

(56) References cited:
- WO-A1-02/17361
- US-A- 5 577 061
- DATABASE WPI Week 198722, Derwent Publications Ltd., London, GB; Class E17, AN 1987-155333, XP002973641 & SU 1 135 382 A (AS USSR RADIOTECHN) 15 October 1986
- JIAN GUI-ZHOU ET AL: 'Study of a new etchant for GaSb/AlGaAsSb device fabrication' JOURNAL OF FUNCTIONAL MATERIALS AND DEVICES vol. 7, no. 1, 2001, pages 1 - 2, XP008034735
- DATABASE WPI Week 197740, Derwent Publications Ltd., London, GB; Class L03, AN 1977-71946Y, XP002973642 & JP 52 035 993 B (MATSUSHITA ELEC IND CO LTD) 12 September 1977
- DATABASE WPI Week 198229, Derwent Publications Ltd., London, GB; Class L03, AN 1982-60969E, XP002973643 & SU 784 635 A (AS USSR RADIO ELTRN) 30 January 1982
- DATABASE WPI Week 200229, Derwent Publications Ltd., London, GB; Class L03, AN 2002-227705, XP002973644 & CN 1 328 175 A (SHNAGHAIMETALLURGY INST CHINESE ACAD SC) 26 December 2001
- WERNER R. ET AL: 'InGaAsSb-AlGaAsSb distributed-feedback lasers emitting at 1.72 um' IEEE PHOTONICS TECHNOLOGY LETTERS vol. 12, no. 8, 08 August 2000, pages 966 - 968, XP000968533

## Description

### Field of the invention

The present invention relates to a process for wet acid etching of AlGaInAsSb structures.

### Background of the invention

A. Li, C. Lin and Y. Zheng, "Chemical etching liquid system for preparing gallium antimonide semiconductor device", CN A 1328175 used an etchant comprising tartaric acid (C₄H₆O₆) with H₂O₂ and HF to etch GaSb-based devices.

P.S. Gladkov et al. "Study of a new chemical etchant for GaSb (100) and (111) substrate preparation for epitaxial growth", pp. 2413-17, Journal of Electrochemical Society, Vol. 142, No. 7 (1995) used an etchant composed of aqueous tartaric acid, H₂O₂, and HF for surface preparation of plain GaSb material. They suggested the following reactions to take place within the resulting solution:

2GaSb + 6H₂O₂ -> Ga₂O₃ + Sb₂O₃ + 6H₂O (1)

Sb₂O₃ + 2C₄H₆O₆ -> 2[Sb(C₄H₂O₆)(H₂O)]⁻ + H₂O + 2H⁺ (2)

Ga₂O₃ + 6HF -> 2GaF₂⁺ + 2F⁻ + 3H₂O (3)

The complex tartaric acid dissolves the antimony oxide, while the hydrofluoric acid dissolves the gallium oxide.

This is in contrast to the Gallium citrate formation observed by G.E. Hawes et al. "Solid and Solution State NMR Spectra and the Structure of the Gallium Citrate Complex (NH4)3[Ga(C6H5O7)2]·4H2O", pp.1005-1011, European Journal of Inorganic Chemistry (2001), in which Ga reacts with citrate.

From G.C. Desalvo et al. "Citric acid etching of GaAs1-xSbx, Al0.5Ga0.5Sb, and InAs for Heterostructure Device Fabrication", pp. 3526-31, Journal of Electrochemical Society, Vol. 141, No. 12 (1994) it is known to use an etchant based on citric acid and H₂O₂ for pattern formation in Ga_{0.5}Al_{0.5}Sb and GaAs₁₋ₓSbₓ material based devices. For GaAs they reported an etch rate of up to 0.3 µm/min, whereas for both GaSb and Ga_{0.5}Al_{0.5}Sb etch rates of less than 10 Å/min were reported in the same solution (9.1 and 0.23 Å/min, respectively).

From H.A. Szymanski et al. "Infrared and Raman studies of arsenic compounds", pp. 297-304, Applied Spectroscopy, Vol. 22, No. 4 (1968) we know that arsenic oxides are soluble in water (but not necessarily in acids under bias conditions, according to X. Li et al. "Arsenic Oxide Micro crystals in Anodically Processed GaAs", pp. 1740-1746, Journal of Electrochemical Society, Vol. 147, No. 5 (2000)).

In the present invention no bias conditions were applied, and therefore we expect the arsenic oxide to be soluble by water reaction alone.

According to Per Kofstad "Inorganic Chemistry. An introduction to the chemistry of the elements", 467 pages (Norwegian), Tano A.S., Oslo (1987), solid As(III) oxide reacts with water in a wet environment:

As₄O₆ + 6H₂O = 4As(OH)₃ (aq) (4)

Thus, As₂O₃ (or As₄O₆) could form As(OH)₃ (or H₃AsO₃) which is then in solution without HF interfering. In an acidic solution, the following reaction would apply:

As(OH)₃ (aq) + H⁺(aq) = As(OH)₂⁺ (aq) + H₂O (5)

Kofstad also reports that Sb in oxidation state +III is little soluble in water.

R.D. Twesten et al. "Microstructure and interface properties of laterally oxidized AixGa1-xAs", pp. 55-61, SPIE, Vol. 3003 (1997) found remaining oxides of (AlₓGa₁₋ₓ)₂O₃, corresponding to Ga₂O₃ in case of GaAs, under oxidation of AlₓGa₁₋ₓAs in wet N₂. This suggests that water alone does not dissolve the Ga oxide as also observed by others (M. J. Howes and D.V. Morgan, "Etching and Surface Preparation of GaAs for Device Fabrication", pp. 119-160, Gallium Arsenide: Materials, Devices and Circuits, John Wiley & Sons Ltd. 1985). It also suggests that water can react with GaAs to form the oxide:

2GaAs + 6H₂O -> Ga₂O₃ + As₂O₃ + 6H₂(g) (6)

The formation of hydrogen would form small gas bubbles if the reaction rate was high.

According to H. Hashimoto et al. "Optical and structural characteristics of Al2O3 films deposited by the reactive ionised cluster beam method", pp. 241-244, Journal of Applied Physics, Vol. 63, no. 1, (1998) deposited Al₂O₃ films were found to be etched by HF, but with an etch rate dependent upon deposition parameters of the Reactive lonised Cluster Beam method. By varying the deposition parameters, the refractive index of the films could be changed (by changing the Al/oxygen ratio of the oxide). This in turn varied the etch rate of the materials with higher etch rate for lower refractive index, indicating that reduced oxygen content reduces etch rate.

M. Ishida et al. "A new etching method for single-crystal Al2O3 film on Si using Si ion implantation", pp. 340-4, Sensors and Actuators A (Physical), Vol. A53, no. 1-3, (1996) observed that HF etched Al₂O₃ with higher rate if Si was incorporated into the material.

S. Ootomo et al. reported in "Properties of as-grown, chemically treated and thermally oxidized surfaces of AlGaN/GaN heterostructure", pp. 934-7, Proceedings of International Workshop on Nitride Semiconductors, Nagoya, Japan, (2000) that a blend of Al₂O₃ and Ga₂O₃ was etched by pure HF, but left F-related impurities.

This suggests to us that the part reaction of aluminium oxide removal will increase with HF concentration in the etchants of the present invention.. This means that the etch rate is also dependent on the Al-concentration in the material that is etched.

J.H. Kim et al. "Selective etching of AlGaAs/GaAs structures using the solutions of citric acid/H2O2 and de-ionized H2O/buffered oxide etch", pp. 558-60, Journal of Vacuum Science Technology, Vol. B16 (1998) observed some etching of AlGaAs by citric acid/H₂O₂. They observed that the etch rate increased with lower Al content and/or with reduced citric acid/H₂O₂ volume ratio. This means that an increased amount of H₂O₂ had to be present in order to reduce the Al oxide at increased Al content. It is therefore probable that the H₂O₂ actually reacts with Al₂O₃ and dissolves this at high concentrations of H₂O₂ and low concentrations of Al. According to P. Kofstad (1987), H₂v₂ can act as a reduction agent. In etching experiments with Al_{1-x-z}GaₓIn_{z}As_{1-y}Sb_{y}, the Al content may be above what can be expected to be soluble at a high etch rate with H₂O₂ being the only reduction agent. We have introduced HF into our etchant in an attempt to increase the solubility of Al oxide during etch of Al_{1-x-z}GaₓIn_{z}As_{1-y}Sb_{y}.

In contradiction to equation (6) suggested by Twesten et al., the etchants according to the present invention does not give noticeable hydrogen formation during GaAs etch. The reaction of GaAs with water is therefore less important for the oxidation of GaAs in our etchants.

We propose that in our case H₂O₂ could react with GaAs causing the formation of Ga and As oxides:

2GaAs + 6H₂O₂ -> Ga₂O₃ + As₂O₃ + 6H₂O (7)

Earlier interpretation of etching experiments on GaSb by P.S.Gladkov et al. does not explain our findings. According to the results of our etching experiments, the Gallium oxide can also be dissolved through some other reaction than equation (3). From etching of GaAs in citric acid/hydrogen peroxide, we have found that a reaction for the solution of Ga₂O₃ could be :

Ga₂O₃ + 4C₆H₈O₇ -> 2[Ga(C₆H₅O₇)₂]³-(aq)+ 3H₂O + 6H⁺ (8)

Ga₂O₃ + 2C₆H₈O₇ -> 2[Ga(C₆H₅O₇)](aq) + 3H₂O (9)

with citric acid for formation of Gallium citrate complexes.

For the other organic acids in the present invention, our etch rates suggests that similar chemical reactions will happen during etch with the other organic acids.

The purpose of the etchants of the present invention is to produce structures in GaSb-based materials with different content of Al, Ga, In, Sb and As. These structures are among others utilized in semiconductor lasers. In such a laser, it is necessary to remove (etch) layers of Al_{1-x-z}GaₓIn_{z}As_{1-y}Sb_{y} in designated areas during processing, in order to define an optical wave guide and electrical injection area. In general, when producing microstructures based on III-V semiconductors, it is necessary to be able to etch the materials. The materials etched by the present invention, are based on GaSb and similar materials with different content of Al,

Ga, In, Sb and As. Conventionally, these materials have been etched with a more expensive dry-etching technique (gas), also referred to as Reactive Ion Etch (RIE), as it has been difficult to find a good wet etchant. It is assumed that difficulties with the etching of these materials, is the main reason for the small use of this material technology beyond lab scale.

The purpose of the present invention is to utilize a mixture of two or more acids and an oxidizing agent in order to produce novel, convenient etchants for such a wet etching process.

The primary object of the present invention is to provide etchants for a new and cost-efficient process for etching of semiconductor structures composed of one or more layers or parts of Al_{1-x-z}GaₓIn_{z}As_{1-y}Sb_{y} with 0<x<1, 0<y<1, 0<z<1 and 0<x+z<1. The importance of these structures in economical views is high as they can be used in a variety of semiconductor photonic devices such as micro lasers and waveguides. AlGaInAsSb-based semiconductor lasers seem to have a promising future as they show high output-power, room-temperature emission, and emit in a range of mid-IR wavelengths. By utilizing wet chemical etching to pattern these structures, cheaper lasers can be made as the need for expensive dry etching equipment (as RIE) can be eliminated. Such cost reduction in manufacturing of semiconductor lasers may eventually lead to a wider use of the lasers. The present invention shows the advantage of organic acids with an oxidizing agent and HF as an etchant for AlGaInAsSb-based materials.

A number of documents in the prior art disclose a wet etchant comprising hydrogen peroxide as an oxidizing agent and hydrofluoric acid, as well as an organic acid contained in this etchant. Amongst these documents are:
- SU 1 135 382 A (As USSR Radiotechn.)
- SU 784 635 A (As USSR Radio Electrn.)
- CN 1 328 175 A (Shanghai Metallurgy Inst. Chinese Academy Sc.)
- Journal of Functional Materials and Devices (Vol. 7, No. 1, 2001)
- JP 52 035 993 B (Matsushita Elec. Industrial Co. Ltd.)

In SU 1 135 382 A and in CN 1 328 175 A the organic acid is lactic acid.

In Journal of Functional Materials and Devices (Vol. 7, No. 1, 2001) and in SU 784 635 A the organic acid is tartaric acid.

In JP 52 035 993 B the organic acid is acetic acid.

### Summary of the Invention

The present invention relates to a process for wet acid etching of intrinsic, n-doped or p-doped Al_{1-x-z}GaₓIn_{z}As_{1-y}Sb_{y} with 0 < x < 1, 0<y<1, 0 < z < 1 and 0< x+z <1, comprising contacting Al_{1-x-z}GaₓIn_{z}As_{1-y}Sb_{y} material with a wet acid etchant comprising:
a) organic acid;
b) oxidizing agent, and
c) hydrofluoric acid in water.
In a further embodiment of the process of the present invention, the organic acid is neat or a mixture.

In the process of the present invention, the organic acid may be selected from citric acid, lactic acid, acetic acid and tartaric acid.

The process of the present invention may be conducted with the oxidizing agent selected from hydrogen peroxide (H₂O₂), sodiumhypochlorite (NaOCI), ozone (O₃) or another oxide-forming chemical.

In one embodiment the process may be conducted with a wet etchant comprising:
a) up to 90 wt-% of organic acid,
b) up to 50 wt-% of oxidizing agent; and
c) up to 25 wt-% of hydrofluoric acid,
all wt-% are based on the total weight of the composition, the balance is made up by a solvent, preferably water.

In another embodiment the process may be conducted with a wet etchant comprising:
a) up to 75 wt-% of organic acid,
b) up to 25 wt-% of oxidizing agent; and
c) up to 15 wt-% of hydrofluoric acid,
all wt-% are based on the total weight of the composition, the balance is made up by a solvent, preferably water.

In an even further embodiment the process may be conducted with a wet etchant comprising:
a) up to 60 wt-% of organic acid,
b) up to 15 wt-% of oxidizing agent; and
c) up to 10 wt-% of hydrofluoric acid.
all wt-% are based on the total weight of the composition, the balance is made up by a solvent, preferably water.

In the process of the present invention, the Al_{1-x-z}GaₓIn_{z}As_{1-y}Sb_{y} semiconductor surface or structure may be patterned with a masking layer prior to the contact with the etchant. The masking material may be selected from a photo resist, oxides, nitrides, carbides, diamond-film, semiconductors or metals.

In the process of the present invention, one or more cap layer(s) may be applied on the Al_{1-x-z}GaₓIn_{z}As_{1-y}Sb_{y} semiconductor surface or structure so that patterning of said semiconductor may be achieved without any contact (reaction) between the surface of the Al_{1-x-z}GaₓIn_{z}As_{1-y}Sb_{y} semiconductor and the masking material. The cap layer may be GaSb, InSb, GaAs, InAs, GaInSb, GaInAs, InAsSb, GaAsSb, GaInAsSb or other non-oxidizing material.

In the whole or parts of the semiconductor material(s) the structure is composed of, may be n-doped with Tellurium or other n-dopant, or p-doped with Beryllium or other p-dopant.

In another embodiment of the present invention, the etched material is part of a laser, Light-Emitting-Diode(LED), photodetector or optical waveguide structure.

The laser or optical waveguide structure, of which the etched material of the present invention is a part, may be a ridge.

The laser, of which the etched material of the present invention is a part, may be a Fabry Perot laser, Distributed Feedback/Reflector Laser (DFB/DBR) or Interferometric laser (as Y-laser or alike).

In another embodiment of the present invention, the etched material of the semiconductor may be part of a Vertical-Cavity Surface-Emitting Laser (VCSEL).

In a further embodiment of the present invention, the etched material of the semiconductor may be part of a photonic crystal structure as Photonic Crystal Distributed Feedback Laser or alike.

In an even further embodiment of the present invention, the etched material of the semiconductor may be part of an optical sensor.

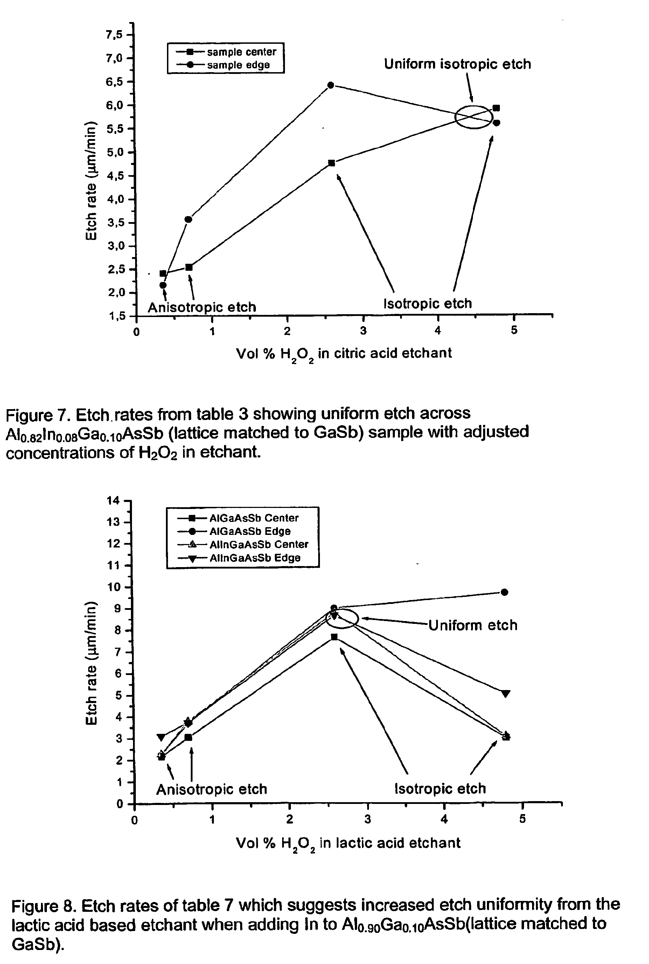

In a further embodiment, the etchant is mixed with the composition in Figure 7 or 8 shown to give a uniform isotropic etch across the etched material.

### Brief description of the Figures

Figure 1 shows SEM images of etch profiles and depths near the photoresist edge for different materials.
Figure 2 shows etch of Al_{0.85}Ga_{0.15}AsSb (lattice matched to GaSb), with low contents of HF. Selectivity of AlGaAsSb over the GaSb cap can be seen (0.3 vol % HF in figure 9).
Figure 3 shows etch rates of Al_{0.82}In_{0.08}Ga_{0.10}AsSb (lattice matched to GaSb) for acetic, lactic and citric acid based etchants as a function of H₂O₂ content (see table 2).
Figure 4 shows etch rates of Al_{0.85}Ga_{0.15}As_{0.06}Sb_{0.94} with etchants containing citric and tartaric acid as shown in table 4.
Figure 5 shows comparison of etch rates for Al_{0.90}Ga_{0.10}AsSb and Al_{0.82}In_{0.08}Ga_{0.10}AsSb (lattice matched to GaSb) with the lactic acid based etchant (see table 5).
Figure 6 shows etch rates of GaAs and GaSb substrates for citric acid and tartaric acid based etchants as shown in table 1.
Figure 7 shows etch rates from table 3 showing uniform etch across Al_{0.82}In_{0.08}Ga_{0.10}AsSb (lattice matched to GaSb) sample with adjusted concentrations of H₂O₂ in etchant.
Figure 8 shows etch rates of table 7 which suggests increased etch uniformity from the lactic acid based etchant when adding In to Al_{0.90}Ga_{0.10}AsSb(lattice matched to GaSb).
Figure 9 shows etch selectivity of Al_{0.85}Ga_{0.10}AsSb (lattice matched to GaSb) versus the GaSb cap (see table 6). Lowering of the HF concentration, reduces the etch rate of GaSb cap more than for Al_{0.90}Ga_{0.10}AsSb.
Figure 10 shows XPS spectra of Al_{0.90}Ga_{0.10}AsSb (lattice matched to GaSb) after etch with etchant with 0.18 M HF
Figure 11 shows XPS spectra of Al_{0.90}Ga_{0.10}AsSb (lattice matched to GaSb) after etch with etchant with 0.9 M HF
Figure 12 shows XPS spectra of Al_{0.90}Ga_{0.10}AsSb (lattice matched to GaSb) after etch with etchant with 0.18 M HF. Al-peak in spectrum shows residue Al oxide on the remaining GaSb substrate after etch.
Figure 13 shows XPS spectra of Al_{0.90}Ga_{0.10}AsSb (lattice matched to GaSb) after etch with etchant with 0.9 M HF. No Al-peak from the remaining GaSb substrate can be seen, but some As and O signal is present (see figure 11).

### Detailed description of the invention.

The present invention is described with basis in the following, non-limiting examples. The patent is intended to cover all possible variations and adjustments, which may be made, based on the appended claims.

### Examples

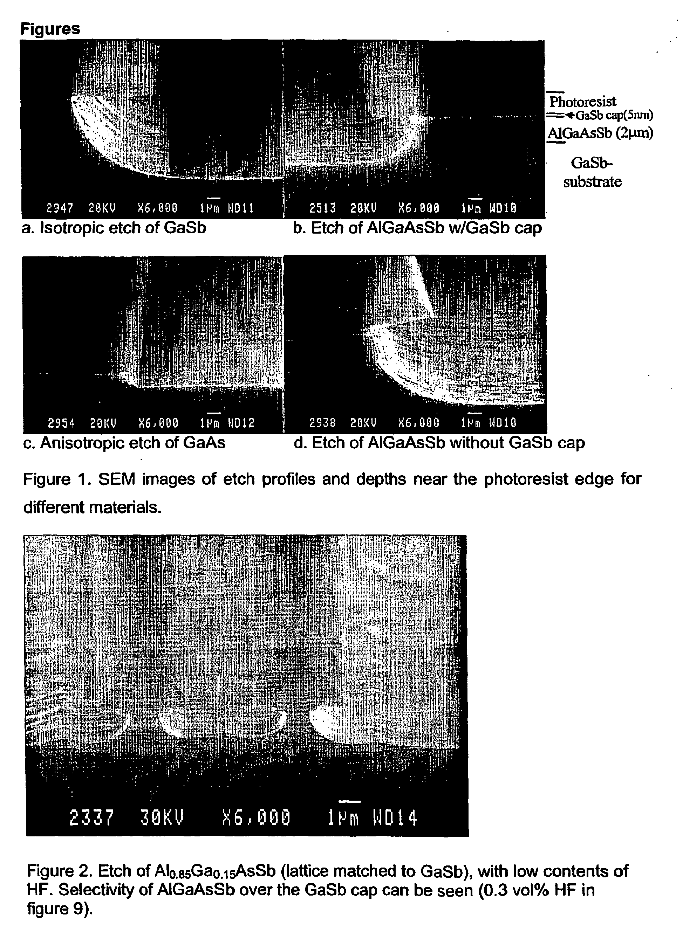

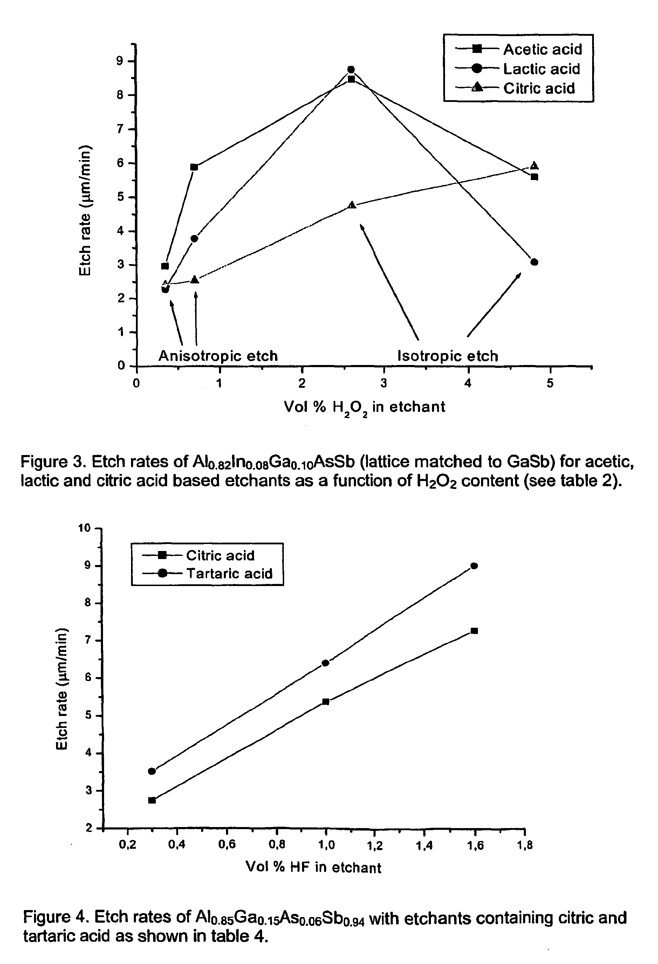

Solutions of citric acid, tartaric acid, lactic acid and acetic acid with H₂O₂ and HF were made to etch patterns into GaAs, GaSb, AlGaAsSb and AlGalnAsSb. The AlGaAsSb and AlGalnAsSb materials had been grown onto GaSb substrates using Molecular Beam Epitaxy (MBE). Broad stripes of photoresist (PR) coating were applied onto the samples using spin-off, contact exposure, and developer. Etching was then carried out on the different samples for up to one minute (with stirring). The resulting etch rates on AlGaAsSb (∼90% Al), AlInGaAsSb (∼8% In), GaSb and GaAs are shown in graphical form in figures 3-9 and in numerical form in tables 1-7. Figure 1 shows some etch profiles in different materials, revealing isotropic etching of GaSb and AlGaAsSb (figure 1 a and 1b, respectively) and anisotropic etching of GaAs (figure 1c). The bending of the photoresist seen in figure 1d is associated with a small beak of reaction products that has appeared between the photoresist and the AlGaAsSb material beneath. We found that formation of a beak could be suppressed by using a cap material as shown in figure 1b (GaSb cap).

**Table 1. Etch rates from etch on GaAs and GaSb substrates by citric and tartaric acid based etchants with 100 ml 2.5 M organic acid, 20 ml 9.8 M H₂O₂ and 0-5 ml 22.6 M HF**

| HF in etchants [Abs.Vol %] | Tartaric acid etchant on GaAs [µm/min] | Tartaric acid etchant on GaSb [µm/min] | Citric acid etchant on GaAs [µm/min] | Citric acid etchant on GaSb [µm/min] |
|---|---|---|---|---|
| 0 | 0.3 | 0 | 0.38 | 0 |
| 0.3 | 0.74 | 5.5 | 0.93 | 4.51 |
| 1 | 0.79 | 8.45 | 0.99 | 7.5 |
| 1.6 | 0.86 | 7.45 | 1.08 | 6.4 |

**Table 2. Etch rates from etch on Al_{0.82}In_{0.08}Ga_{0.1}AsSb with 100 ml 2.5 M organic acid, 1.25-20 ml 9.8 M H₂O₂ and 5 ml 22.6 M HF.**

| H₂O₂ in etchant [Abs.Vol %] | Actetic acid based etch [µm/min] | Lactic acid based etch [µm/min] | Citric acid based etch [µm/min] |
|---|---|---|---|
| 0.35 | 2.96 | 2.27 | 2.41 |
| 0.7 | 5.89 | 3.78 | 2.54 |
| 2.6 | 8.48 | 8.77 | 4.75 |
| 4.8 | 5.6 | 3.08 | 5.92 |

**Table 3. Uniformity of etch rate for etch on Al_{0.82}In_{0.08}Ga_{0.1}AsSb with 100 ml 2.5 M citric acid, 1.25-20 ml 9.8 M H₂O₂ and 5 ml 22.6 M HF.**

| H₂O₂ in etchant [Abs.Vol %] | Sample centre etch rate [µm/min] | Sample edge etch rate [µm/min] | Change centre vs. edge, etch type* |
|---|---|---|---|
| 0.35 | 2.41 | 2.16 | +12%, Anisotropic |
| 0.7 | 2.54 | 3.56 | -29%, Anisotropic |
| 2.6 | 4.75 | 6.40 | -26%, Isotropic |
| 4.8 | 5.92 | 5.6 | +6%, Isotropic |

| | | | |
|---|---|---|---|
| *[Change centre vs. edge]=[Etch rate at sample centre]/[Etch rate at sample edge]-1 | | | |

**Table 4. Etch rates from etch on Al_{0.85}Ga_{0.15}As_{0.06}Sb_{0.94} by citric and tartaric acid based etchants with 100 ml 2.5 M organic acid, 20 ml 9.8 M H₂O₂ and 1-5 ml 22.6 M HF**

| HF in etchants [Abs.Vol %] | Citric acid etchant [µm/min] | Tartaric acid etchant[µm/min] |
|---|---|---|
| 0.3 | 2.74 | 3.52 |
| 1 | 5.37 | 6.4 |
| 1.6 | 7.26 | 9 |

**Table 5. Comparison between etch on Al_{0.9}Ga_{0.1}AsSb and Al_{0.82}In_{0.08}Ga_{0.1}AsSb with 100 ml 2.5 M Lactic acid, 1.25-20 ml 9.8 M H₂O₂ and 5 ml 22.6 M HF.**

| H₂O₂ in etchant [Abs.Vol %] | Lactic acid etch on AlGaAsSb [µm/min] | Lactic acid etch on AlInGaAsSb [µm/min] |
|---|---|---|
| 0.35 | 2.15 | 2.27 |
| 0.7 | 3.04 | 3.78 |
| 2.6 | 7.63 | 8.77 |
| 4.8 | 3.00 | 3.08 |

**Table 6. Selectivity in etch of MBE grown GaSb cap over Al_{0.85}Ga_{0.15}As_{0.06}Sb_{0.94} with 100 ml 2.5 M citric acid, 20 ml 9.8 M H₂O₂ and 1-5 ml 22.6 M HF.**

| HF in etchants [Abs.Vol %] | Etch rate on AlGaAsSb [µm/min] | Etch rate on GaSb cap [µm/min] | Selectivity of AlGaAsSb over GaSb cap |
|---|---|---|---|
| 0.3 | 2.74 | 1.54 | 1.78 |
| 1 | 5.37 | 4.98 | 1.08 |
| 1.6 | 7.26 | 6.78 | 1.07 |

**Table 7. Comparison between etch uniformity on Al_{0.9}Ga_{0.1}AsSb and Al_{0.82}In_{0.08}Ga_{0.1}AsSb (lattice matched to GaSb) with 100 ml 2.5 M lactic acid, 1.25-20 ml 9.8 M H₂O₂ and 5 ml 22.6 M HF.**

| H₂O₂ in etchant [Abs. Vol %] | Etch rate at AlGaAsSb centre [µm/min] | Etch rate at AlGaAsSb edge [µm/min] | Change centre vs. edge* | Etch rate at AlInGaAsSb centre [µm/min] | Etch rate at AlInGaAsSb edge [µm/min] | Change centre vs. edge* |
|---|---|---|---|---|---|---|
| 0.35 | 2.15 | 2.24 | -4% | 2.27 | 3.10 | -27% |
| 0.7 | 3.04 | 3.70 | -18% | 3.78 | 3.72 | +1% |
| 2.6 | 7.63 | 8.98 | -15% | 8.77 | 8.64 | +2% |
| 4.8 | 3.00 | 9.68 | -69% | 3.08 | 5.2 | -41% |

| | | | | | | |
|---|---|---|---|---|---|---|
| *[Change centre vs. edge]=[Etch rate at sample centre]/[Etch rate at sample edge]-1 | | | | | | |

It can be seen from table 5 that replacing of 8% the Al with In increases all etch rates.

It can be seen from table 7 that the resulting surface after etch shows better etch uniformity for Al_{0.82}In_{0.08}Ga_{0.1}AsSb than for Al_{0.9}Ga_{0.1}AsSb.

It was found that the etchants with citric acid and lactic acid could be used for highly uniform etching of AlGaInAsSb (figures 7 and 8) and fairly good uniform etching of AlGaAsSb (figure 8). Selectivity of AlGaAsSb over GaSb could be obtained by reducing HF concentration in the etchant (see figure 2). These two results are important in order to utilize the etchants for industrial applications.

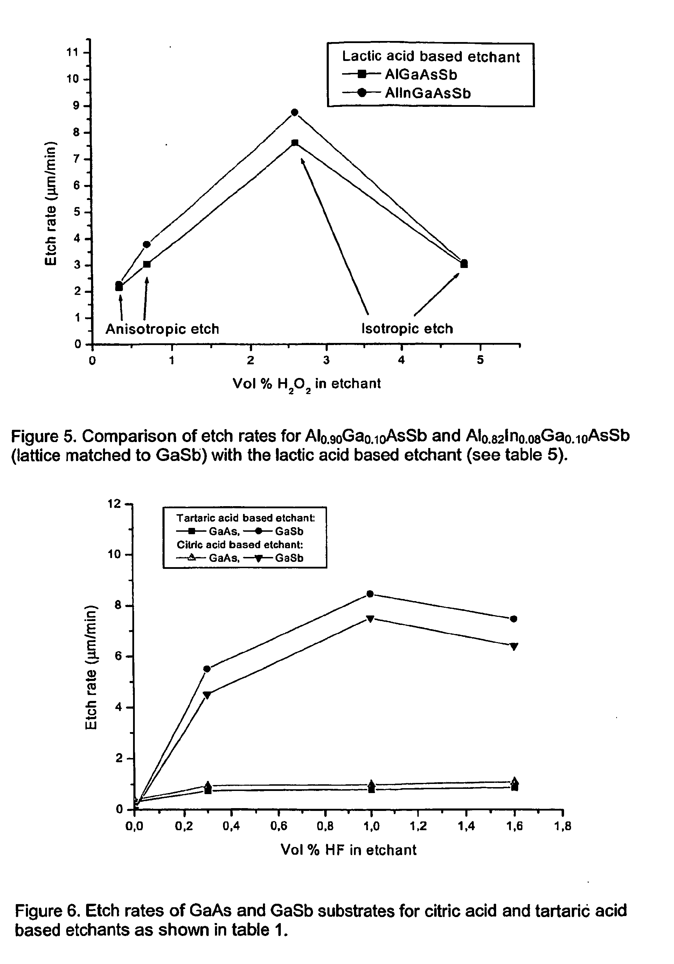

From figure 6 and table 1, it is seen that the organic acid/H₂O₂ solutions without HF etches GaAs but not GaSb at an observable rate. This suggests that the formed Sb oxide (Sb₂O₃) (see equation 1, page 1) is not significantly dissolved by any of the organic acids, which is in contrast to the chemical equations proposed by P.S.Gladkov et al. (1995). All As oxides are highly soluble in water (M. J. Howes and D.V. Morgan (1985)), whereas Sb oxides are little soluble in water (P. Kofstad (1987)).

Since GaSb is etched by the solution containing HF, the following reaction could apply:

Sb₂O₃ + 6H⁺ + 6F⁻ -> 2SbF₂⁺(aq) + 2F⁻ + 3H₂O (10)

Since HF(aq) is a weak acid, the direct reaction with H⁺:

Sb₂O₃ + 2H⁺ + H₂O = 2Sb(OH)₂⁺ (or = 2SbO⁺(aq) + H₂O) (11)

is probably less important. These equations can be seen to explain a process in which HF is speeding up the dissolution of Sb-oxides into the etchant.

Since the Sb oxide is little soluble in water we can probably disregard any influence of such reactions.

The complex acid etches of the GaSb based semiconductors gave isotropic and smooth surfaces (see figure 1a-b) for a range of ingredient concentrations. At low H₂O₂ concentration in the etchant, however, most GaSb-based materials showed surface roughness and/or anisotropic etching (see figure 3 and 5). For all etchants, some variation of etch rate was observed across the specimens. Generally, it was observed for all the specimens that the etch rate at the edge of the specimen was different from the etch rate at the middle of the specimen. Local variations of etch rates were also observed and were probably due to diffusion limited reactions: Near PR edges, the etching rate was generally lower than for the open areas far from the PR. The variations could be eliminated or reduced by adjusting the composition of the etchant, as shown in figure 7 and 8, giving an isotropic etch with uniform etch rate and smooth surfaces.

Figure 4 and 6 show that the etch rates on GaSb and AlGaAsSb increase with increasing HF content in the tartaric and citric acid based etchants. The small drop in etch rate of GaSb (figure 6) for the highest concentration of HF indicates a second diffusion-limited reaction in our etchants. This might be explained via the increased reaction rates for HF-related reactions with increased HF concentration. At high reaction rates, reaction products may not have time to diffuse away, causing reduced etch rates. At even higher HF concentrations, concentration gradients will be reduced, contributing to less diffusion of products and thereby a further reduction in the etch rate.

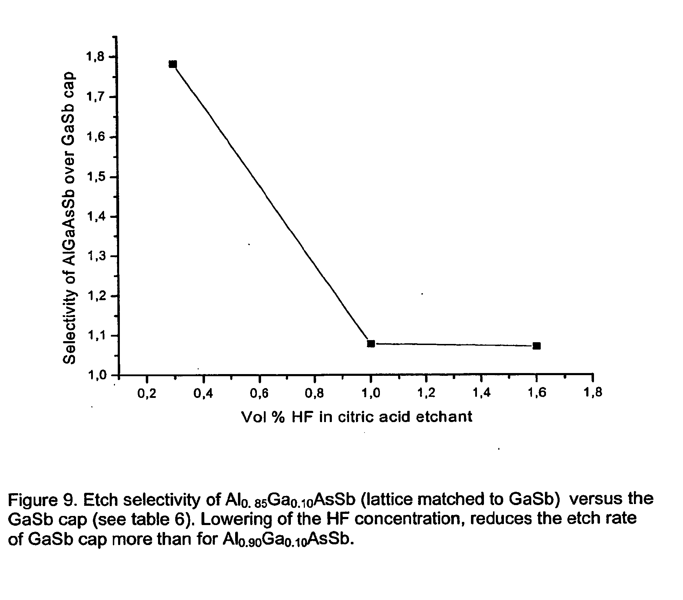

Our results show that the organic acid based etchant can have good uniformity during etch of AlGaAsSb and AlInGaAsSb materials, resulting in good planarity and smooth surfaces. Results also show highly uniform etch regions of some etchants (figure 7 and 8). This can indicate that citric acid and lactic acid are favorable over acetic acid and tartaric acid for etching AlInGaAsSb. We also showed that increased selectivity of AlGaAsSb over the GaSb cap can be obtained by adjusting the HF composition of the etchant (figure 9).

### X-Ray Photoelectron Spectroscopy (XPS)

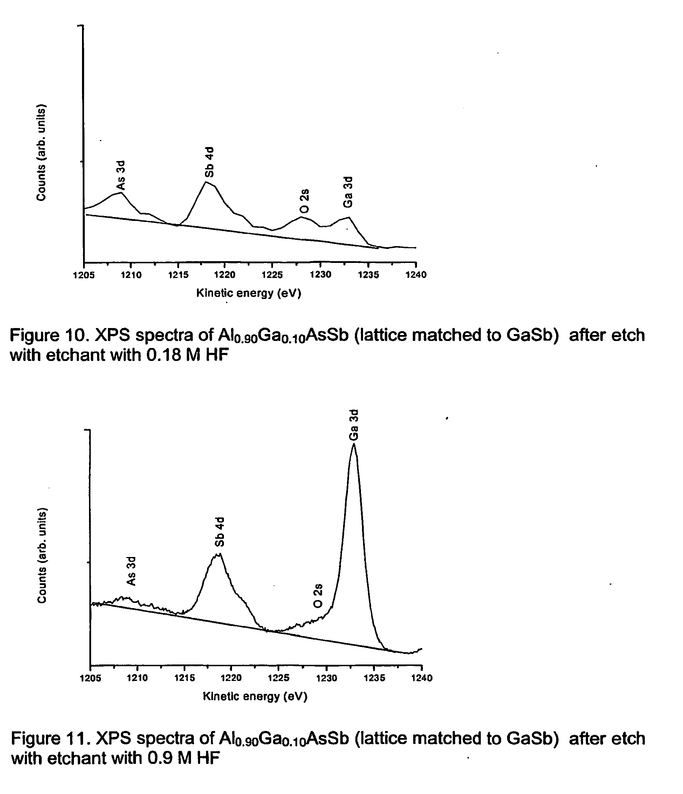

To examine surface composition of AlGaAsSb after etch, x-ray photoelectron spectroscopy (XPS) experiments were carried out. Pieces of the same material without PR were etched and XPS spectra collected from the samples. XPS spectra from the characterization of etched AlGaAsSb is shown in figure 10-13.

In order to carry out these XPS examinations, two specimens of a 2 µm thick Al_{0.85}Ga_{0.15}As_{0.06}Sb_{0.94} epilayer on a GaSb substrate were etched for one minute in an etchant with 2.5 M citric acid, 9.8 M H₂O₂ and HF (100:20:x), one solution with 0.18 M HF (x=1) and one with 0.9 M HF (x=5, see figure 4 or table 4 for etch rates). This was supposed to remove the 2 µm thick AlGaAsSb epilayer, so that only the GaSb along with any surface oxides would be present.

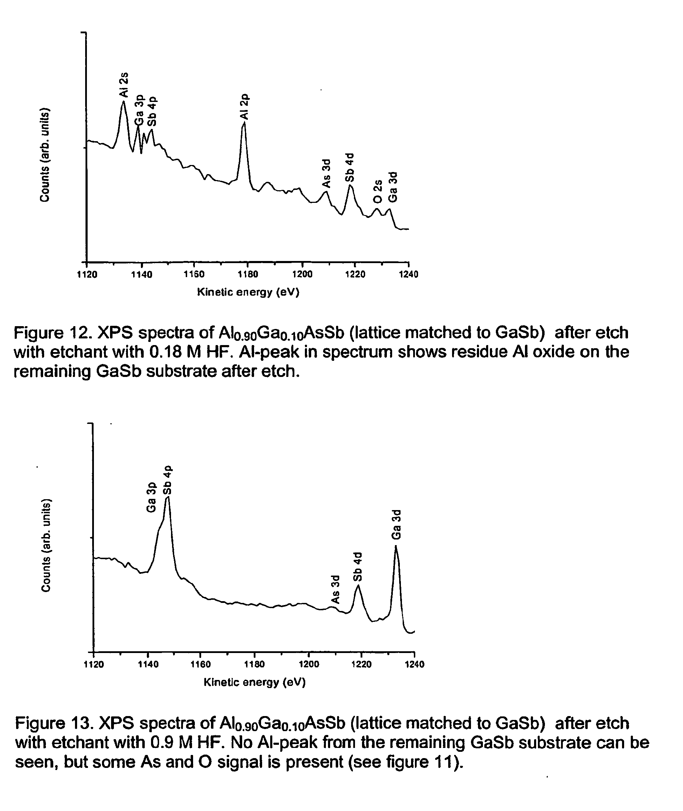

XPS measurements revealed residue Al on/near the surface of the etched specimen with etchant containing little HF (0.18 M) (see figure 12). This specimen also showed oxygen peaks, but very little Ga-signal, indicating an Al-containing oxide remaining on the surface. This was not the case when etching with the etchant containing more HF (0.9 M). This specimen showed no Al 2p peak (figure 13), which indicates that the Al-containing oxide is removed on/near the surface. The low HF-containing etchant might not have removed all of the epilayer material, probably due to a low dissolution rate of the Al-oxide which leaves Al-containing residues.

Comparing figure 4 and 6, we can see that the etch rate of AlGaAsSb (figure 4) can increase to above that of the GaSb substrate (figure 6) when increasing the HF concentration in the etchant. This means that the etch rate of As- or Al-oxide increase with HF concentration to a level above that of Ga- and/or Sb-oxide. The As 3d peak (figure 10 and 11) was present in both specimens, which indicates that there is some As-containing residue left on both surfaces. By also considering the 85% Al and 6% As content of the AlGaAsSb material, the Al oxide must be much more soluble than the As oxide for the high HF-containing etchant (with 0.9 M HF, i.e. 1.6 Vol % HF). We can therefore conclude that the reaction with HF is faster for Al than for Ga, meaning that the Ga-citrate formation proposed in equation (8) and (9) must be important for the present invention.

## Claims

1. A process for wet acid etching a semiconductor containing Al, Ga, In, As, and Sb, wherein a wet acid comprising a mixture of
a) an organic acid,
b) an oxidizing agent, and
c) hydrofluoric acid
in water, is brought in contact with an intrinsic, n-doped or p-doped semiconductor corresponding to the formula
Al_{1-x-z}GaₓIn_{z}As_{1-y}Sb_{y} in which 0<x<1, 0<y<1, 0<z<1, and 0<x+z<1.

2. The process according to claim 1, wherein the organic acid is neat or a mixture.

3. The process according to claim 1, wherein the organic acid is selected from citric acid, lactic acid, acetic acid or tartaric acid.

4. The process according to claim 1, wherein the oxidizing agent is hydrogen peroxide (H₂O₂) or alike oxide-forming chemical.

5. The process according to any one of claims 1-4, wherein the wet acid etchant comprises:
a) 0 to 90 w/v-% of the organic acid;
b) 0 to 50 w/v-% of oxidizing agent; and
c) 0 to 25 w/v-% of hydrofluoric acid,
all wt-% are based on the total weight of the composition, the balance is made up by a solvent, preferably water.

6. The process according to any one of claims 1-4, wherein the wet acid etchant comprises:
a) 0 to 75 w/v-% of the organic acid;
b) 0 to 25 w/v-% of oxidizing agent; and
c) 0 to 15 w/v-% of hydrofluoric acid,
all wt-% are based on the total weight of the composition, the balance is made up by a solvent, preferably water.

7. The process according to any one of claims 1-4, wherein the wet acid etchant comprises:
a) 0 to 60 w/v-% of the organic acid;
b) 0 to 15 w/v-% of oxidizing agent; and
c) 0 to 10 w/v-% of hydrofluoric acid,
all wt-% are based on the total weight of the composition, the balance is made up by a solvent, preferably water.

8. The process according to any one of claims 1-4, wherein the wet acid etchant comprises:
a) 12-45 %w/v of the organic acid;
b) 0.4-5.6 %w/v of oxidizing agent; and
c) 0.4-2.1 %w/v of hydrofluoric acid,
the balance being made up by a solvent, preferably water.

9. The process according to any one of claims 1-4, wherein one or more cap layer(s) is (are) applied on the Al_{1-x-z}GaₓIn_{z}As_{1-y}Sb_{y} semiconductor surface or structure so that patterning of said semiconductor is achieved without any reaction at the interface between the surface of the Ak_{1-x-z}GaₓIn_{z}As_{1-y}Sb_{y} semiconductor and a masking material which is also applied on the semiconductor surface.

10. A process according to claim 9, wherein the cap layer is GaSb, InSb, GaAs, InAs, GaInSb, GaInAs, InAsSb, GaAsSb, GaInAsSb or other non-oxidizing material and the masking material is selected from a photo resist, oxides, nitrides, carbides, diamond-film, semiconductors or metals.

11. The process according to any one of claims 1-4, wherein at least part of the Al_{1-x-z}GaₓIn_{z}As_{1-y}Sb_{y} semiconductor material the structure is composed of, is n-doped with Tellurium or other n-dopant, or p-doped with Beryllium or other p-dopant.

## Patentansprüche

1. Ein Verfahren für die Nass-Säureätzung eines Halbleiters enthaltend Al, Ga, In, As und Sb, wobei eine Nass-Säure umfassend ein Gemisch aus
a) einer organischen Säure,
b) einem Oxidationsmittel, und
c) Fluorwasserstoffsäure
in Wasser, in Kontakt mit einem intrinsischen, n-dotierten oder p-dotierten Halbleiter gebracht wird, entsprechend der Formel Al_{1-x-z}GaₓIn_{z}As_{1-y}Sb_{y}, in der 0<x<1, 0<y<1, 0<z<1, und 0<x+z<1.

2. Das Verfahren nach Anspruch 1, wobei die organische Säure unverdünnt oder ein Gemisch ist.

3. Das Verfahren nach Anspruch 1, wobei die organische Säure aus Zitronensäure, Milchsäure, Essigsäure oder Weinsäure selektiert wird.

4. Das Verfahren nach Anspruch 1, wobei das Oxidationsmittel Wasserstoffperoxid (H₂O₂) oder eine ähnliche oxidbildende Chemikalie ist.

5. Das Verfahren nach irgendeinem der Ansprüche 1-4, wobei das Nass-Säureätzmittel umfasst:
a) 0 bis 90 w/v-% (Gewicht-zu-Volumen-Verhältnis) der organischen Säure;
b) 0 bis 50 w/v-% (Gewicht-zu-Volumen-Verhältnis) von Oxidationsmittel; und
c) 0 bis 25 w/v-% (Gewicht-zu-Volumen-Verhältnis) von
Fluorwasserstoffsäure,
alle wt-%-Angaben basieren auf dem Gesamtgewicht der Zusammensetzung, der Ausgleich besteht aus einem Lösungsmittel, vorzugsweise Wasser.

6. Das Verfahren nach irgendeinem der Ansprüche 1- 4, wobei das Nass-Säureätzmittel umfasst:
a) 0 bis 75 w/v-% (Gewicht-zu-Volumen-Verhältnis) der organischen Säure;
b) 0 bis 25 w/v-% (Gewicht-zu-Volumen-Verhältnis) von Oxidationsmittel; und
c) 0 bis 15 w/v-% (Gewicht-zu-Volumen-Verhältnis) von
Fluorwasserstoffsäure,
alle wt-%-Angaben basieren auf dem Gesamtgewicht der Zusammensetzung, der Ausgleich besteht aus einem Lösungsmittel, vorzugsweise Wasser.

7. Das Verfahren nach irgendeinem der Ansprüche 1-4, wobei das Nass-Säureätzmittel umfasst:
a) 0 bis 60 w/v-% (Gewicht-zu-Volumen-Verhältnis) der organischen Säure;
b) 0 bis 15 w/v-% (Gewicht-zu-Volumen-Verhältnis) von Oxidationsmittel; und
c) 0 bis 10 w/v-% (Gewicht-zu-Volumen-Verhältnis) von
Fluorwasserstoffsäure,
alle wt-%-Angaben basieren auf dem Gesamtgewicht der Zusammensetzung, der Ausgleich besteht aus einem Lösungsmittel, vorzugsweise Wasser.

8. Das Verfahren nach irgendeinem der Ansprüche 1-4, wobei das Nass-Säureätzmittel umfasst:
a) 12-45 %w/v (Gewicht-zu-Volumen-Verhältnis) der organischen Säure;
b) 0,4-5,6 %w/v (Gewicht-zu-Volumen-Verhältnis) von Oxidationsmittel; und
c) 0,4-2,1 %w/v (Gewicht-zu-Volumen-Verhältnis) von Fluorwasserstoffsäure,
der Ausgleich bestehend aus einem Lösungsmittel, vorzugsweise Wasser.

9. Das Verfahren nach irgendeinem der Ansprüche 1-4, wobei eine oder mehrere Deckschicht(en) auf die Al_{x-z}GaₓIn_{z}As_{1-y}Sb_{y} Oberfläche oder Struktur des Halbleiters aufgebracht wird (werden), sodass eine Strukturierung des besagten Halbleiters erreicht wird ohne jeglicher Reaktion an der Schnittstelle zwischen der Oberfläche des Al_{1-x-z}GaₓIn_{z}As_{1-y}Sb_{y} Halbleiters und einem Abdeckmaterial, das ebenfalls auf die Oberfläche des Halbleiters aufgebracht wird.

10. Ein Verfahren nach Anspruch 9, wobei die Schutzschicht GaSb, InSb, GaAs, InAs, GaInSb, GaInAs, InAsSb, GaAsSb, GaInAsSb oder ein anderes nicht oxidierendes Material ist und das Abdeckmaterial aus einem Fotolack, Oxiden, Nitriden, Karbiden, Diamantfilm, Halbleitern oder Metallen selektiert wird.

11. Das Verfahren nach irgendeinem der Ansprüche 1-4, wobei zumindest ein Teil des Al_{1-x-z}GaₓIn_{z}As_{1-y}Sb_{y} Halbleitermaterials, aus dem die Struktur sich zusammensetzt, mit Tellur oder einem anderen n-Dotand n-dotiert-, oder mit Beryllium oder einem anderen p-Dotand p-dotiert ist.

## Revendications

1. - Procédé de gravure acide humide d'un semi-conducteur contenant Al, Ga, In, As et Sb, suivant lequel un acide humide comprenant un mélange de
a) un acide organique ;
b) un agent oxydant ; et
c) de l'acide fluorhydrique ;
dans l'eau, est amené en contact avec un semi-conducteur intrinsèque, dopé n ou dopé p correspondant à la formulé :
Al_{1-x-y}GaₓIn_{z}As_{1-y}Sb_{y} dans laquelle 0<x<1, 0<y<1, 0<z<1 et 0<x+z<1.

2. - Procédé selon la revendication 1, dans lequel l'acide organique est pur ou un mélange.

3. - Procédé selon la revendication 1, dans lequel l'acide organique est choisi parmi l'acide citrique, l'acide lactique, l'acide acétique ou l'acide tartrique.

4. - Procédé selon la revendication 1, dans lequel l'agent oxydant est le peroxyde d'hydrogène (H₂O₂) ou un produit chimique formant un oxyde similaire.

5. - Procédé selon l'une quelconque des revendications 1 à 4, dans lequel l'agent de gravure acide humide comprend :
a) 0 à 90 % en p/v de l'acide organique ;
b) 0 à 50 % en p/v d'agent oxydant ; et
c) 0 à 25% en p/v d'acide fluorhydrique, tous les % en poids étant basés sur le poids total de la composition, le complément étant composé d'un solvant, de préférence d'eau.

6. - Procédé selon l'une quelconque des revendications 1 à 4, dans lequel l'agent de gravure acide humide comprend :
a) 0 à 75 % en p/v de l'acide organique ;
b) 0 à 25 % en p/v d'agent oxydant ; et
c) 0 à 15 % en p/v d'acide fluorhydrique,
tous les % en poids étant basés sur le poids total de la composition, le complément étant composé d'un solvant, de préférence d'eau.

7. - Procédé selon l'une quelconque des revendications 1 à 4, dans lequel l'agent de gravure acide humide comprend :
a) 0 à 60 % en p/v de l'acide organique ;
b) 0 à 15 % en p/v d'agent oxydant ; et
c) 0 à 10 % en p/v d'acide fluorhydrique,
tous les % en poids étant basés sur le poids total de la composition, le complément étant composé d'un solvant, de préférence d'eau.

8. - Procédé selon l'une quelconque des revendications 1 à 4, dans lequel l'agent de gravure acide humide comprend :
a) 12 à 45 % en p/v de l'acide organique ;
b) 0,4 à 5,6 % en p/v d'agent oxydant ; et
c) 0,4 à 2,1 % en p/v d'acide fluorhydrique,
le complément étant composé d'un solvant, de préférence d'eau.

9. - Procédé selon l'une quelconque des revendications 1 à 4, dans lequel une ou plusieurs couches de recouvrement est ou sont appliquées sur la surface ou structure du semi-conducteur Al_{1-x-z}GaₓIn_{z}As_{1-y}Sb_{y} de telle sorte que la formation de motif dudit semi-conducteur est obtenue sans une quelconque réaction à l'interface entre la surface du semi-conducteur Al_{1-x-z}GaₓIn_{z}As_{1-y}Sb_{y} semi-conducteur et une matière de masquage qui est également appliquée sur la surface du semi-conducteur.

10. - Procédé selon la revendication 9, dans lequel la couche de recouvrement est GaSb, InSb, GaAs, InAs, GaInSb, GaInAs, InAsSb, GaAsSb, GaInAsSb ou autre matière non oxydante et la matière de masquage est choisie parmi un photorésist, les oxydes, les nitrures, les carbures, un film de diamant, les semi-conducteurs ou les métaux.

11. - Procédé selon l'une quelconque des revendications 1 à 4, dans lequel au moins une partie du matériau semi-conducteur Al_{1-x-z}GaₓIn_{z}As_{1-y}Sb_{y} dont la structure est composée est dopée n par le tellure ou autre dopant n, ou dopée p par du béryllium ou autre dopant p.
